Europäisches Patentamt

European Patent Office

Office européen des brevets

(11) Publication number: 0 336 173
A2

# (12) EUROPEAN PATENT APPLICATION

(21) Application number: 89104831.6

(22) Date of filing: 17.03.89

(51) Int. Cl.⁴: H01L 23/30 , H01L 23/56

(30) Priority: 05.04.88 US 177724

(43) Date of publication of application:
11.10.89 Bulletin 89/41

(84) Designated Contracting States:
DE FR GB IT

(71) Applicant: Siemens Aktiengesellschaft
Wittelsbacherplatz 2
D-8000 München 2(DE)

(72) Inventor: Wiese, Lynn Karl
3534 Butcher Drive
Santa Clara, CA 95051(US)

(54) Molded component package isolating interior substrate by recesses containing exposed breakoffs.

(57) A molded package (32) for an electrical or elec-
tronic component subject to voltage surges includes
a metallic substrate (28, 29) isolated to withstand the
potential of the voltage surges. The isolation is pro-
vided by locating breakoff points (31) for the sup-
ports of the substrate (28, 29) prior to the molding
operation within the interior most portions of reces-
ses (36, 37) in the molded package. This technique
therefore provides a long arc path from the exposed
breakoff to proximate points of potential difference
due to the occurence of the voltage surges.

FIG. 1

# MOLDED COMPONENT PACKAGE ISOLATING INTERIOR SUBSTRATE BY RECESSES CONTAINING EXPOSED BREAKOFFS

## BACKGROUND OF THE INVENTION

This invention relates to optically triggered semiconductor switching components wherein the full extent of the high voltage isolation characteristics of the triggering via optical coupling is realized between the intput and output terminals of such components. More specifically, the invention relates to improving the high voltage isolation provided by convenient and cost effective techniques for packaging solid-state relays.

Conventional solid-state components are manufactured using lead frames in strip form wound on reels to provide continuous feeding for sequential processing operations during assembly. For example, such a packaging process is disclosed for low voltage signal applications in U.S. Patent No. 4,214,364 of J.R. St. Louis et al. issued on July 29, 1980 . In the final stages of such a process, transfer molding typically occurs before the trimming operation wherein metallic material bridging between successive packages is severed. For such low voltage signal applications, isolating the substrate on which the active or passive electrical and electronic devices are mounted is rather trivial and readily accomplished.

In the case of power devices, such as solid-state relays, opto-couplers, power devices and the like, effective isolation of metallic substrates by the sequence of processing steps in conventional techniques present a significant problem due to high voltage surges common to such applications. Specifically, the metallic substrate supported within the lead frame is required to be electrically isolated in the finished package to withstand voltages surges. In the steps of the conventional packaging techniques, the trimming operation usually exposes a metal breakoff connected to the substrate which has a relatively short arc path to ground potential. This is particularly true since such power devices have a flat mounting surface for facilitating thermal conductivity from the internal substrate to a heat sink to meet the requirements for heat dissipation. Since such heat sinks are typically metallic in the interest of high thermal conductivity and efficient dissipation, a high voltage surge is able to bridge or arc over between the substrate and the heat sink.

One solution is to provide an insulative substrate such as some kind of ceramic material, but its use requires extra processing steps to attach metal lead thereto by soldering, for example, which requires heating to temperatures incompatible with the temperature range of materials involved in the packaging process. Due to the cost of a ceramic substrate and the extra processing attendant to its use, this solution increases the overall cost of power components deploying ceramic substrates. Also, the brittleness of ceramic materials renders these packages more suspectible to mechanical damage.

## SUMMARY OF THE INVENTION

It is an object of the present invention to provide a packaging technique for power applications wherein a metallic substrate is utilized in a manner having superior electrical isolation of the substrate from the external environment of the package.

A related object of the invention is to achieve such electrical isolation to withstand high voltage surges without significantly appreciable high additional costs.

A further object of the invention is to achieve high electrical isolation of the substrate from the external environment of its working applications without adding troublesome or burdensome processing steps.

Broadly, the invention takes the form of a molded package for an electronic circuit component or the like having an internal metallic substrate to which a circuit element is mounted. The molded package is subjected to voltage surges providing potential differences between the internal metallic substrate and points exterior thereto. The molded package has at least one recessed portion co-located with a breakoff point of a member supporting the internal metallic substrate prior to formation of the molded package. This arrangement providing a breakoff point located within the most interior portion of the recessed portion.

In some of the further aspects of the invention, at least two recesses are used each co-located with a breakoff support for the metallic substrate. The circuit component also includes a plurality of leads whose interior free ends are connected to the electrodes of the circuit elements located within the molded package. Specifically, there are four leads of which two serve as input terminals and two serve as output terminals. When a solid state relay serves as the electronic circuit component, a light emitting semiconductor is connected to the two input terminals and an optotriac response to the emission of semiconductor by turning on by completing a conductive path between the two output terminals.

## BRIEF DESCRIPTION OF THE DRAWING

Features of the invention and additional objects of the invention will be more readily appreciated and better understood by reference to the following detailed description which should be considered in conjunction with the drawing.

Fig. 1 illustrates three contiguous packaging positions in a continuous lead frame.

Figs. 2 and 3 provide cross-sectional views of different portions of the lead frame of Fig. 1.

Fig. 4 illustrates the formation of a molded package body on one of the packaging positions of the lead frame of Fig. 1.

Figs. 5 and 6 provide cross-sectional views of different portions of the packaging body of Fig. 4.

Fig. 7 is a perspective view of a single package developed utilizing the lead frame of Fig. 1.

Fig. 8 provides an internal schematic representation of a typical chip installation within the package of Fig. 7.

## DETAILED DESCRIPTION

Throughout the following description of the various drawing figures corresponding or duplicative elements are designated by common reference numerals.

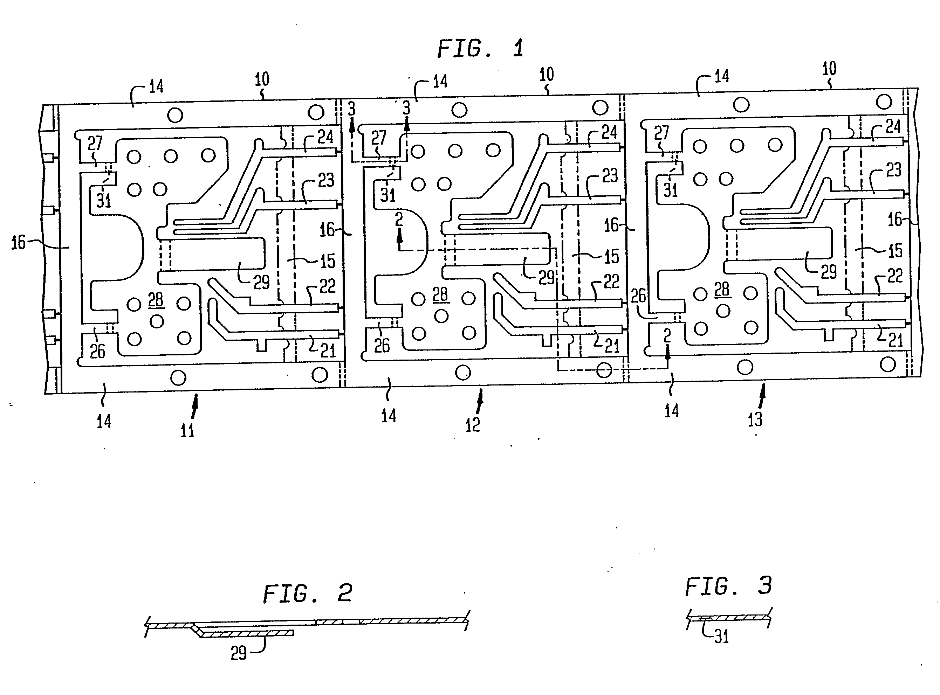

In Fig. 1, a section of a lead frame indicated generally at 10, with three chips or die positions indicated at 11, 12 and 13. The lead frame has parallel, spaced apart, side members 14 and parallel spaced apart transverse members 16.

A removable webbed section 15 is shown in phantom since it serves no permanent purpose and is used in the lead frame to provide a temporary support until its removal after the component body is molded.

Members 16 extend between and connect to the side members 14. From one side, each transverse 16 provides support for the narrowed ends of pins or terminals 21-24 while the opposite side provides two supporting tabs 26 and 27 for a somewhat irregular shaped region designated as metallic substrate 28. An elongated area of substrate 28 serves a die chip pad 29. It should be noted that the free ends of pins or leads 21-24 are terminated within the proximity of pad 29 for purposes of convenient wire stitch bonding.

Fig. 2 is a cross-sectional view along axis 2-2 of lead frame 10 in Fig. 1. In Fig. 2, it is clear that die chip mounting pad 29 is formed to be slightly offset from the general plane of the lead frame 10. This arrangement facilitates the mounting of optotriac chip on pad 29 while a light emitting diode is situated on lead 22 and is electrically coupled to lead 21. In this case, leads 21 and 22 provide an input pair of terminals to a light emitting diode while the optotriac is connected to output leads 23 and 24. Although a light emitting diode input device and an output optotriac are used in conjunction, it should be understood that a wide variety of input and output electronic components may be used to advantage. Furthermore, the principles of the invention are readily applicable to any electrical or electronic component application wherein it is desired to have a metallic substrate sufficiently isolated so as to withstand the high voltage potential in surges or otherwise of numerous power applications.

Fig. 3 depicts an enlarged cross-sectional portion along axis 3-3 in Fig. 1. The cross-section depicted in Fig. 3 is characteristic of all tabs 26 and 27 in Fig. 1. Specifically present in Fig. 3 is reduced cross-sectional thickness breakoff 31. Breakoff 31 present in each of tabs 26 and 27 is reduced to approximately one-half thickness by etching or otherwise forming to locate the breakoff point accurately for tabs 26 and 27. Although this breakoff 31 is formed from the backside of lead frame 10, it may in principle be formed from either side that is front or back.

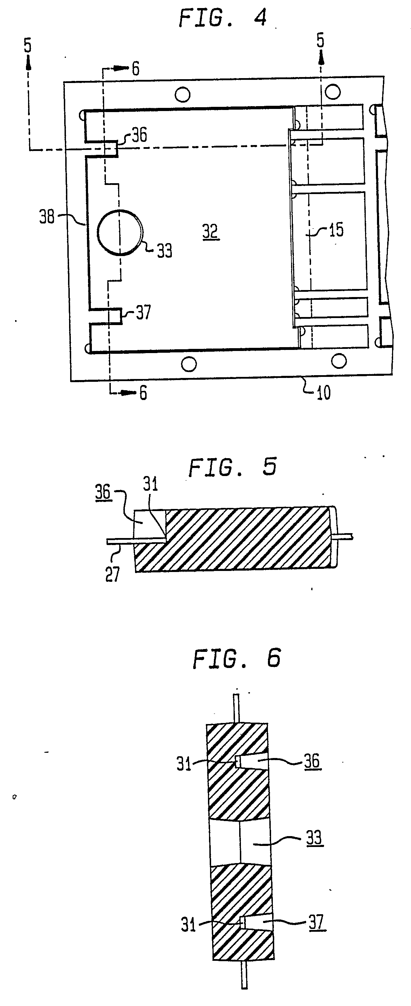

Fig. 4 illustrates the presence of a transfer molding package 32 corresponding to a die position on lead frame 10. For mounting purposes, a hole 33 is present for securing the finished package to a suitable heat sink. Fig. 5 is a first cross section along axis 5-5 in Fig. 4 taken through the package at one of notches 36 and 37 which each contain one of the breakoffs 31 of tabs 26 and 27. A primary feature of the present invention is the location of breakoff points at breakoffs 31 each deeply recessed within one of notches 36 and 37. Such an arrangement provides an arc path of significantly increased length than if the breakoff occurred at side wall 38 of the package of Fig. 4. Furthermore, the length of the arc path can be readily controlled by the selection of suitable dimensions of notch 36 and also notch 37.

Fig. 6 depicts another cross-section of the package of Fig. 4 along axis 6-6 and through notches 36 and 37 and mounting hole 33. In Fig. 6, the location of each one of breakoffs 31 is present at the bottom of its respective notch. Furthermore, deep within the interior of each of notches 36 and 37 are of breakoffs 31 is located as illustrated in Fig. 5. From the respective views Figs. 4, 5 and 6, each one of breakoffs 31 is in effect surrounded by a substantial amount of the insulative material of mold 32 to provide highly effective insulative barriers which could only be traversed by the development of a very long arc path whose voltage is selected to exceed the peak voltage surges anticipated to be experienced in the working application of the power component housed within the illustrative embodiment of the invention.

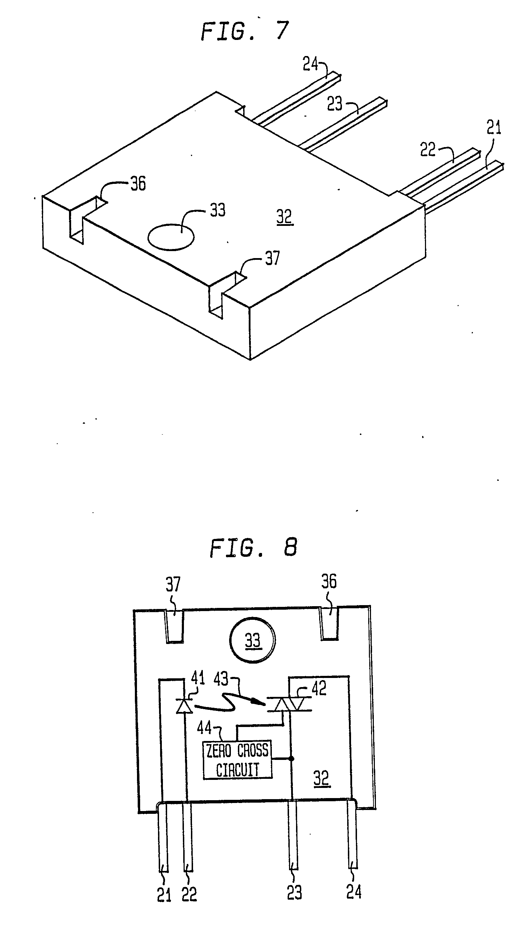

Fig. 7 depicts a perspective view of a single molded package 32 having terminal leads 21-24, mounting hole 33, and notches 36 and 37. A typical internal circuit diagram for molded body 32 is schematically illustrated in Fig. 8. Light emitting diode 41 emits optical energy which illuminates optotriac 42 internally within the molded package 32 of Fig. 8 via optical coupling path 43. In practice, diode 41 may be an infrared light emitting diode that it is present with optotriac 42 in a bead of transparent material which forms the optical coupling path 43. Then, the optical coupling arrangement is encased in the insulative material of package 32 which is heavily black pigmented to prevent ambient light from operating or even affecting the operation of optotriac 42. The black color of body 32 also enhances the radiational heat dissipation of the package. In addition, optional zero voltage crossing sensing circuit 44 may be present to allow triac 42 to fire at the zero crossing point of the alternating current line voltage present at leads 23 and 24.

An advantage of the geometrical configuration of the recess or notch located at the breakoff is the elimination of an additional molding or potting step in the manufacturing process.

Although the heat sink for the component package described is contemplated as essentially having a flat surface, the heat sink may take the form of a clip which clamps over the body of the component and having its own mounting arrangement, typically a mounting hole. When the component is flatly mounted to heat sink, hole 33 provides passage for a screw or other axial securing hardware which may not only secure the body to the heat sink but also secure the heat sink itself. In any case, the principles herein described have numerous applications to any molded package encasing a metallic substrate required to be isolated from its working environment. In these cases, the actual internal circuit arrangement housed within the package may take on any desired form suitable for its application.

There has thus been shown and described a novel packaging arrangement which fulfills all the objects and advantages sought therefor. Many changes, modifications, variations and other uses and applications of the subject invention will, however, become apparent to those skilled in the art after considering this specification and the accompanying drawing which disclose the preferred embodiments thereof. For example, suitable variations of the physical arrangements described in the foregoing may become apparent. For example instead of notches corresponding to the location of breakoffs for the metallic substrate, a drilling operation at a location corresponding to the breakoff may be performed. In such an arrangement, drilling would only occur to a predetermined depth just sufficient to provide the breakoff so that the breakoff is housed within the bottom on a cylindrical recess. All such changes, modifications, variations and other uses and applications which do not depart from the spirit and scope of the invention are deemed to be covered by the invention which is limited only by the claims which follow.

## Claims

1. A generally encapsulated power component subject to voltage surges, the power component comprising a molded body having an internal element-supporting member for mounting a circuit element thereon, the molded body formed by transfer molding on a lead frame to encase the internal element-supporting number and the circuit element, the element-supporting member being supported by at least one tab bridging between the lead frame, the molded body having at least one recessed portion co-located with the at least one tab, the at least one tab having a portion of reduced strength for providing a pre-disposed breakoff point within the most interior portion of the at least one recessed for isolating the element-supporting member to withstand the voltage surges.

2. The power component of claim 1 further comprising a plurality of terminal leads extending from the interior of the molded body for providing external connections while the interior end of the terminals leads is connected to an electrode of the circuit element.

3. The power component of claim 2 further comprising a second recessed portion in the molded body and a second tab for supporting the internal element supporting member co-located with each other to provide a second portion of reduced strength for a second breakoff point within the interior portion of the second recess.

4. The power component of claim 3, wherein the plurality of terminal leads are disposed to a common peripheral side of the molded body opposite from the at least one recess and the second recess disposed on a second common peripheral side.

5. A packaged component comprising an internal element-supporting member having a planar region on its major surface to which the internal element is fixed, a molded portion of insulative molding material encasing the element-supporting member including the internal element, and at least one tab serving to support the element-supporting members extending from its exterior towards a peripheral surface of the molding portion, the at least one tab having a breakoff region of reduced cross-section while the molded portion has a notched shaped recess corresponding to the location of the breakoff region so that the at least one tab is severed at the breakoff region providing an exposure location for the element-supporting member within the confines of the notched shaped recess whereby isolation of the element-supporting member is able to withstand voltage surges of at least one kilovolt.

6. A power semiconductor component subject to voltage surges, the component comprising a molded body of insulative material and an internal element-supporting member required to be isolated to withstand the voltage surges, the molded body having at least one recess extending internally from an exterior surface of the molded body, a breakoff point located within the recess remaining from a member providing support for the internal element-supporting member whereby the recess increases the distance of a potential arc path from the breakoff point to a point of potential difference with respect to the internal element-supporting member.

7. The power component of claim 6 further comprising a second recessed portion in the molded body and a second tab for supporting the internal element supporting member co-located with each other to provide a second portion of reduced strength for a second breakoff point within the interior portion of the second recess.

8. The power component of claim 7 further comprising a plurality of terminal leads extending from the interior of the molded body for providing external connections while the interior end of the terminals leads is connected to an electrode of the circuit element.

9. The power component of claim 8, wherein the plurality of terminal leads are disposed to a common peripheral side of the molded body opposite from the at least one recess and the second recess disposed on a second common peripheral side.

10. The power component of claim 9, wherein the plurality of terminal leads comprises two input terminal leads and two output terminal leads, the internal element comprises an optotriac connected to the two output terminal leads, and further comprising a light emitting semiconductor connected to the two input terminal leads for optically operating the optotriac in response to an input current.

11. The power component of claim 9, wherein the internal element further comprises zero crossing means coupled to the optotriac for allowing to be turned on at the zero crossing point of an alternating current potential applied to the two output terminal leads.

12. The power component of claim 10, wherein the light emitting semiconductor comprises an infrared light emitting diode.

FIG. 1

FIG. 2

FIG. 3

EP 0 336 173 A2

## FIG. 4

## FIG. 5

## FIG. 6

## FIG. 7

## FIG. 8

ZERO CROSS
CIRCUIT